# EUROPEAN PATENT SPECIFICATION

(11) **EP 0 389 964 B1**
(45) Date of publication and mention of the grant of the patent: **12.10.1994**
(21) Application number: 90105425.4
(22) Date of filing: 22.03.1990
(51) Int. Cl.: H01L 29/60, H01L 29/73

(54) **Manufacturing process for a bridged-emitter doped-silicide transistor**
Verfahren zur Herstellung eines Transistors mit aus dotiertem Silizid überbrücktem Emitter
Procédé de fabrication d'un transistor ayant une couche de siliciure dopé au dessus de l'émetteur

(30) Priority: 28.03.1989 US 329457
(43) Date of publication of application: 03.10.1990
(73) Proprietor: NATIONAL SEMICONDUCTOR CORPORATION, Santa Clara California 95051-8090 (US)
(72) Inventor: Vora, Madhukar B., Chandler, Arizona 85224 (US)
(74) Representative: Sparing Röhl Henseler Patentanwälte

(56) References cited:
- EP-A- 0 036 620
- GB-A- 2 168 845

## Description

This invention relates to a method of fabricating a bipolar transistor structure tending to minimize the effective area of the transistor.

Numerous techniques for fabricating bipolar transistors are now well known. Also well known are techniques for isolating bipolar transistors from each other by forming them in epitaxial pockets of silicon electrically isolated from surrounding areas of the silicon substrate. See, for example, U.S. Patent No. 3,648,125 (′125) which describes what has become known as the isoplanar process.

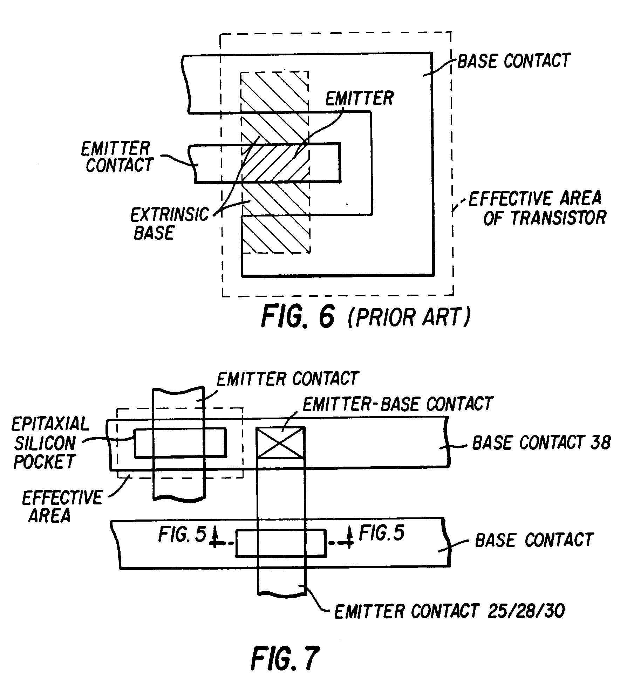

Bipolar transistors using polycrystalline silicon contacts to form electrodes, as well as metal silicide contacts, also are well known. Unfortunately, in almost all of the bipolar transistors of the prior art, making electrical connections to the base to minimize the base resistance requires connections to be made on opposite sides of the emitter. This has been achieved using a strip of conductive material which, when viewed from above, "zig-zags" around the emitter connection to form a contact to the base on each side of the emitter. In other words, the connection to the base of the bipolar transistor tends, when viewed from above, to have a configuration shaped like a "C" with the emitter connection extending into the opening in the "C". Figure 6 illustrates this topology of a typical prior art bipolar device.

One unfortunate disadvantage of such prior art devices is that the effective area of the transistor, that is, the minimum surface area of silicon required to form a transistor, requires provision for the large amount of area consumed by the interconnections. Although to some extent these interconnections may overlie oxidized isolation regions in the substrate, or other regions used to electrically isolate the transistors from each other, they undesirably increase the silicon area required for the fabrication of each transistor, thereby substantially decreasing the density with which devices may be formed.

Because the yield of good integrated circuits from a given wafer is directly related to the area which such circuits occupy, it is extremely desirable to minimize the size of such circuits. Minimizing the size of the circuits not only increases the yield of good devices from a wafer, but also because of the essentially fixed cost of processing a single wafer, lowers manufacturing costs. Alternatively, for a given size circuit, minimizing the transistor size allows a larger number of devices to be fabricated on a chip, thereby increasing the capability of the chip.

Document EP-A-36 620 discloses a method for making a transistor structure wherein the C-configuration referred to above is avoided in that the base connection bridges the emitter connection, an insulating sheath on the latter preventing shortings. A wet etch process removes undesired portions of said insulating sheath to get access to the underlying base regions. Any mask misalignment will result in a defective device.

The present invention as defined by patent claim 1 provides an unisotropic etch process which is much less prone to expose the emitter contact.

Document GB-A-2 168 845 discloses a method of making bipolar transistor structures. The method includes the step of unisotropically etching an isolating layer so that a poly emitter contact and a base contact are separated by the oxidized sidewalls of the emitter poly. A blanket metal layer is formed on the structure, silicide is formed where Si is exposed, and the nonreacted metal is removed.

Figure 1 is a cross-sectional view of an integrated circuit structure which may be fabricated using known techniques.

Figure 2 is a subsequent cross-sectional view after deposition of materials used for the emitter contact and formation of the emitter.

Figure 3 is a subsequent cross-sectional view after definition of the emitter contact and formation of an insulating layer.

Figure 4 is a subsequent cross-sectional view after anisotropic etching of the insulating layer.

Figure 5 is a subsequent cross-sectional view after deposition of a layer of electrically conductive material used to define the base electrode.

Figure 6 is a top view of a prior art structure.

Figure 7 is a top view of a structure fabricated using this invention.

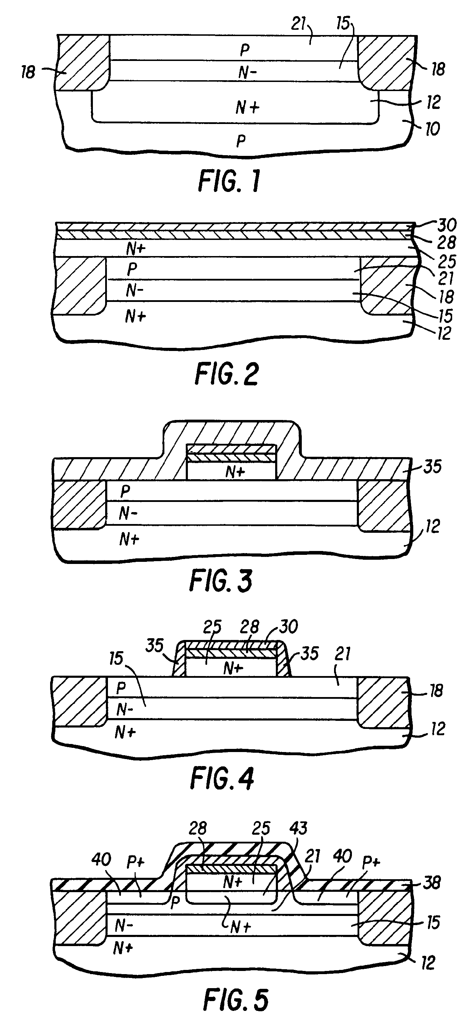

Figures 1-5 illustrate a preferred embodiment of the process of the invention by which a bridged-emitter doped-silicide transistor is formed. The process results in the fabrication of a bipolar transistor having the minimum possible effective area. Figure 1 illustrates a starting semiconductor structure for performing the invention. The structure depicted in Figure 1 may be fabricated using any desired known technique, for example, as described in the above ′125 patent. The structure shown in Figure 1 includes a monocrystalline silicon substrate of 100 crystal orientation which is lightly doped with P-type impurity. A heavily doped N conductivity type region 12 is diffused or implanted into substrate 10 using conventional masking techniques. On the upper surface of substrate 10 another monocrystalline silicon layer 15 is deposited using conventional epitaxial techniques. Layer 15 is lightly doped with N-type impurity, and ultimately functions as the collector of the bipolar transistor to be formed. Buried layer 12 provides a connection to the collector.

Next, using the techniques described in ′125, oxidized isolation regions 18 are formed, preferably of silicon dioxide. If desired, a P conductivity type channel stop region may be introduced into the substrate beneath the oxidized isolation to prevent channeling. Of course, other isolation techniques may also be employed. The oxidized isolation region 18 forms a pocket in the epitaxial layer which surrounds and isolates a region of the epitaxial layer from surrounding regions of the wafer. The bottom of the pocket is formed by the buried layer 12. Lastly, using conventional techniques, P-type impurity is introduced into the surface of epitaxial layer 15 to form a region 21 adjacent the upper surface. Region 21 will ultimately provide the extrinsic and intrinsic base of the bipolar transistor.

As shown in Figure 2, the layer of polycrystalline silicon 25 is deposited across the upper surface of the structure, for example, using chemical vapor deposition. The thickness of polycrystalline silicon 25 will be approximately 2500 to 5000 Angstroms, (10Å = 1nm) and in accordance with the invention, layer 25 is strongly doped with N conductivity type impurity. Depending upon the particular circuit in which the bipolar transistor is employed, polycrystalline silicon layer 25 may be employed for other purposes, and if so, a mask may be employed to confine the doping of layer 25 to those regions where the emitters of bipolar transistors are desired. Next, a layer of a metal which forms a silicide compound is deposited across the upper surface of the structure and reacted with the underlying polycrystalline silicon 25 to form metal silicide 28. Alternatively, the silicide may be formed by being deposited as a silicide directly onto polycrystalline silicon 25. In the preferred embodiment, the silicide includes appropriate N conductivity type dopant such as arsenic. Silicide layer 28 is preferably about 500 to 1000 Angstroms. The structure then is oxidized to form a layer of silicon dioxide 30 across the upper surface of silicide 28. In the preferred embodiment, this layer is approximately 2000 Angstroms thick.

Next, and not shown in the figures, a mask is formed across the upper surface of the structure and the undesired portions of silicon dioxide 30, silicide 28, and polycrystalline silicon 25 etched away, preferably using an anisotropic process. The desired portions of these layers remain on the surface of the structure wherever electrical connections to the emitter are desired, for example, as depicted in Figure 3. Then, a relatively thick layer of vapor-deposited silicon dioxide 35 is deposited across the entire structure as shown in Figure 3.

Then, as shown by Figure 4, another anisotropic etching process removes the vapor-deposited silicon dioxide 35 from the surface of the substrate. By discontinuing the process after the surface is exposed, regions of silicon dioxide 35 will remain as shown in Figure 4 on the sidewalls of the emitter contact.

As next shown in Figure 5, a layer of metal silicide 38 doped with P conductivity type impurity is deposited across the upper surface of the structure. Layer 38 preferably will be about 1000 Angstroms thick. The layer 38 then is masked and undesired portions removed. In general, layer 38 is allowed to remain only where base contacts to the bipolar transistor are desired, or connections between the base of the bipolar transistor and other devices are desired.

The structure is then heated to a temperature of 900°C and held there for 10 minutes to cause P-type impurity in the silicide 38 to diffuse into the substrate to form extrinsic base contacts 40. At the same time, N conductivity type impurity, typically arsenic, diffuses from the emitter silicide contact 28 through the polycrystalline layer 25 and into the substrate 21 to form an emitter 43. Figure 5 depicts the completed structure with region 12 providing a contact to the collector 15, region 21 functioning as a base, and regions 40 serving as the base contacts. Region 43 is the emitter which is contacted by emitter contact 25/28, while the base contacts 40 are connected by electrode 38.

A primary advantage of the structure fabricated using the process described above is that it results in a transistor having a minimum area. This is illustrated by a comparison of Figures 6 and 7. Figure 6 illustrates a conventional bipolar transistor as viewed from the top, i.e., looking down upon the wafer upon which it is fabricated. As shown, the bipolar device includes an emitter contact to an emitter as well as a base contact which shorts the extrinsic base connections on each side of the emitter together. The effective area of the transistor is considerable in view of the need to route the base contact around the emitter contact.

In contrast, the bridged-emitter doped-silicide transistor of the invention results in a substantially smaller effective area. Figure 7 illustrates how the emitter contact is formed from one strip extending in a first direction, while the base contact, which is connected to the extrinsic base on each side of the emitter, is formed by a second strip orthogonal to the emitter contact. The invention is also advantageous in that it allows simple interconnections between transistors, for example as depicted by the area designated emitter-base contact in Figure 7. In such a region, the silicon dioxide layer 30, normally separating the base contact 38 from the emitter contact silicide 28, is removed before deposition of the base contact. The result is that the base contact 38 shorts to the emitter contact 28, thereby connecting the emitter of one transistor to the base of another transistor.

Although the foregoing has been a description of the preferred embodiment of the invention, it will be appreciated that certain details have been provided to enable a complete understanding of the process and structure. These details are for the purpose of explanation, and are not intended to limit the invention, which is characterized by the appended claims.

## Claims

1. A method of fabricating a semiconductor transistor structure comprising the steps of:
providing a substrate having at least a first region of first conductivity type, said first region (15) having an upper surface;
forming a second region (21) of second conductivity type, said second region located adjacent said upper surface;
forming a layer of polysilicon adjacent said second region;
forming a first insulating layer (30) on said layer of polysilicon;
masking a desired portion of said first insulating layer, said desired portion covering an emitter contact region (45) of said polysilicon,
removing an un-masked portion of said first insulating layer, and further removing said polysilicon region beneath said un-masked region to expose said second region, thereby defining a first conductive electrode (25) to said emitter contact region;
forming a second insulating layer (35) on said first insulating layer and said exposed second region;
anisotropically removing said second insulating layer forming an isolation region on sidewalls of said emitter contact; and
forming a second conductive electrode (38), said second conductive electrode disposed on said insulating layers on said emitter contact and in contact with said exposed second region.

2. The method as recited in claim 1 wherein said first region is formed by depositing epitaxial silicon doped with an N-type impurity.

3. The method as recited in claim 1 wherein the step of forming a first conductive electrode on said polysilicon region further comprises the steps of:
depositing a layer of metal on said second region; and
reacting said metal with said second region to form metal silicide.

4. The method as recited in claim 1 wherein the step of forming a second electrode comprises the steps of:
depositing a metal silicide (38) doped with a second conductivity type;
masking said silicide;
removing undesired portions of said silicide; and
causing said second conductivity type to diffuse into said exposed portion.

5. The method as recited in claim 1 wherein said exposed second region comprises a first exposed area on a first side of said emitter contact and a second exposed area on a second side of said emitter contact.

## Patentansprüche

1. Ein Verfahren zum Herstellen einer Halbleitertransistorstruktur, umfassend die Schritte:
Bereitstellen eines Substrats mit zumindest einem ersten Bereich eines ersten Leitfähigkeitstyps, welcher erste Bereich (15) eine obere Oberfläche aufweist;
Bilden eines zweiten Bereichs (21) des zweiten Leitfähigkeitstyps, welcher zweite Bereich neben der oberen Oberfläche angeordnet ist;
Bilden einer Schicht aus Polysilicium nahe dem zweiten Bereich;
Bilden einer ersten Isolationsschicht (30) auf der Polysiliciumschicht;
Maskieren eines gewünschten Abschnitts der ersten Isolierschicht, welcher gewünschte Abschnitt einen Emitterkontaktbereich (43) des Polysiliciums überdeckt;
Abtragen eines nichtmaskierten Abschnitts der ersten Isolationsschicht und weiterer Abtrag des Polysiliciumbereichs unter dem unmaskierten Bereich zum Freilegen des zweiten Bereichs, wodurch eine erste leitende Elektrode (25) zu dem Emitterkontaktbereich begrenzt wird;
Bilden einer zweiten Isolierschicht (35) auf der ersten Isolierschicht und dem exponierten zweiten Bereich;
anisotroper Abtrag der zweiten Isolationsschicht zur Bildung eines Isolationsbereichs auf Seitenwandungen des Emitterkontakts; und
Bilden einer zweiten leitenden Elektrode (38), welche zweite leitende Elektrode auf den Isolierschichten, auf dem Emitterkontakt und in Kontakt mit dem freigelegten zweiten Bereich angeordnet ist.

2. Das Verfahren nach Anspruch 1, bei dem der erste Bereich durch Aufbringen epitaxialen Siliciums, dotiert mit einem N-Typ Dotiermittel, gebildet wird.

3. Das Verfahren nach Anspruch 1, bei dem der Schritt der Bildung einer ersten leitenden Elektrode auf dem Polysiliciumbereich ferner die Schritte umfaßt:
Aufbringen einer Metallschicht auf dem zweiten Bereich; und
Reagierenlassen des Metalls mit dem zweiten Bereich zur Bildung von Metall-Silicid.

4. Das Verfahren nach Anspruch 1, bei dem der Schritt der Bildung einer zweiten Elektrode die Schritte umfaßt:
Aufbringen eines Metall-Silicids (38), dotiert mit einem zweiten Leitfähigkeitstyps;
Maskieren des Silicids;
Abtrag unerwünschter Abschnitte des Silicids; und Diffundierenlassen des zweiten Leitfähigkeitstyps in den freigelegten Abschnitt.

5. Das Verfahren nach Anspruch 1, bei dem der freigelegte zweite Bereich ein erstes freigelegtes Areal auf einer ersten Seite des Emitterkontakts umfaßt und ein zweites freigelegtes Areal auf einer zweiten Seite des Emitterkontakts.

## Revendications

1. Procédé de fabrication d'une structure de transistor semiconducteur comprenant les étapes de :
fournir un substrat ayant au moins une première région d'un premier type de conductivité, ladite première région (15) ayant une surface supérieure;
former une deuxième région (21) d'un deuxième type de conductivité, ladite deuxième région étant adjacente à ladite surface supérieure;
former une couche de poylsilicium adjacente à ladite deuxième région;
former une première couche d'isolation (30) sur ladite couche de polysilicium;
masquer une partie désirée de ladite première couche d'isolation, ladite partie désirée couvrant une région de contact d'émetteur (43) dudit polysilicium;
éliminer une partie non masquée de ladite première couche d'isolation et éliminer en outre ladite région de silicium se trouvant sous ladite région non masquée pour exposer ladite deuxième région définissant ainsi une première électrode conductrice (25) en contact avec ladite région de contact d'émetteur;
former une deuxième couche d'isolation (35) sur ladite première couche d'isolation et ladite deuxième région exposée;
éliminer de façon anisotrope ladite deuxième couche d'isolation formant une région d'isolation sur des parois latérales dudit contact d'émetteur; et
former une deuxième électrode conductrice (38), ladite deuxième électrode conductrice étant disposer sur lesdites couches d'isolation sur ledit contact d'émetteur et en contact avec ladite deuxième région exposée.

2. Procédé de fabrication selon la revendication 1 dans lequel ladite première région est formée en déposant du silicium epitaxial dopé avec une impureté de type N.

3. Procédé de fabrication selon la revendication 1, dans lequel l'opération de formation de la première électrode conductrice sur ladite région de polysilium comprend en outre les étapes de :
déposer une couche de métal sur ladite deuxième région; et
faire réagir ledit métal avec ladite deuxième région pour former un siliciure métallique.

4. Procédé selon la revendication 1 dans lequel l'opération de formation d'une deuxième électrode comprend les opérations de :
déposer un siliciure métallique (38) dopé avec un deuxième type de conductivité;
masquer ledit siliciure;
éliminer les parties non désirées dudit siliciure; et
faire diffuser ledit deuxième type de conductivité dans ladite partie exposée.

5. Procédé selon la revendication 1 dans lequel ladite deuxième région exposée comprend une première surface exposée sur un premier côté dudit contact d'émetteur et une deuxième surface exposée sur un deuxième côté dudit contact d'émetteur.
